# EUROPEAN PATENT APPLICATION

(11) **EP 4 456 124 A1**
(43) Date of publication of application: **30.10.2024**
(21) Application number: 24165852.5
(22) Date of filing: 25.03.2024
(51) Int. Cl.: H01L 21/822, H01L 21/8238, H01L 27/092, H01L 29/06, H01L 29/775, H01L 27/06

(54) **INTEGRATED CIRCUIT DEVICE INCLUDING STACKED TRANSISTORS AND METHODS OF FABRICATING THE SAME**

(30) Priority: 26.04.2023 US 202363498355 P; 23.05.2023 US 202363468437 P; 20.09.2023 US 202318470684
(71) Applicant: Samsung Electronics Co., Ltd., Suwon-si, Gyeonggi-do 16677 (KR)
(72) Inventor: YANG, Myung, San Jose, CA 95134 (US); YUN, Seungchan, San Jose, CA 95134 (US); PARK, Sooyoung, San Jose, CA 95134 (US); LEE, Jaehong, San Jose, CA 95134 (US); SEO, Kang-Ill, San Jose, CA 95134 (US)
(74) Representative: Kuhnen & Wacker Patent- und Rechtsanwaltsbüro PartG mbB

(57) **Abstract**

Integrated circuit devices and methods of forming the same are provided. The integrated circuit devices include a transistor on a substrate. The transistor includes: a pair of thin semiconductor layers (130) spaced apart from each other; a channel region (202) between the pair of thin semiconductor layers; a gate electrode on the pair of thin semiconductor layers and the channel region; and a gate insulator separating the gate electrode from both the pair of thin semiconductor layers and the channel region. A side surface of the channel region is recessed with respect to side surfaces of the pair of thin semiconductor layers and define a recess (204) between the pair of thin semiconductor layers. A portion of the gate insulator (122) and optionally a portion of the gate electrode is in the recess.

## Description

### BACKGROUND

The present disclosure generally relates to the field of integrated circuit devices and, more particularly, to integrated circuit devices including stacked transistors.

Various structures of an integrated circuit device and methods of forming the same have been proposed to increase the integration density. For example, a stacked transistor structure including multiple transistors vertically stacked has been proposed.

### SUMMARY

An integrated circuit device, according to some embodiments, may include a transistor on a substrate. The transistor may include: a pair of thin semiconductor layers spaced apart from each other; a channel region between the pair of thin semiconductor layers; a gate electrode on the pair of thin semiconductor layers and the channel region; and a gate insulator separating the gate electrode from both the pair of thin semiconductor layers and the channel region. A side surface of the channel region may be recessed with respect to side surfaces of the pair of thin semiconductor layers and may define a recess between the pair of thin semiconductor layers. A portion of the gate insulator may be in the recess. In some embodiments, a portion of the gate electrode may also be in the recess.

An integrated circuit device, according to some embodiments, may include a first transistor and a second transistor stacked on a substrate. The first transistor may include: a pair of thin semiconductor layers spaced apart from each other; a first channel region between the pair of thin semiconductor layers; a first gate electrode on the pair of thin semiconductor layers and the first channel region; and a first gate insulator separating the first gate electrode from both the pair of thin semiconductor layers and the first channel region. The second transistor may include: a second channel region; a second gate electrode on the second channel region; and a second gate insulator separating the second gate electrode from the second channel region. The first channel region and the second channel region may not be spaced apart from each other in a vertical direction that is perpendicular to an upper surface of the substrate and overlap each other in the vertical direction, and the first channel region may include a material different from the second channel region.

A method of forming an integrated circuit device, according to some embodiments, may include forming a first transistor and a second transistor on a substrate. The first transistor may include a channel structure and a first gate electrode on the channel structure, and the channel structure may include a pair of thin semiconductor layers and a first channel region that may be between the pair of thin semiconductor layers and may contact the pair of thin semiconductor layers. The second transistor may include a second channel region and a second gate electrode on the second channel region. The second channel region and the channel structure may be spaced apart from each other in a vertical direction and may overlap each other in the vertical direction. The first channel region may include a material different from the pair of thin semiconductor layers.

A method of transmitting a signal, according to some embodiments, may include applying a signal to a first source/drain of a transistor and applying a control signal to a gate electrode of the transistor. The applying the control signal to the gate electrode may allow the signal to be transmitted to a second source/drain of the transistor through a channel region of the transistor. In some embodiments, the transistor may include: a pair of thin semiconductor layers spaced apart from each other; the channel region between the pair of thin semiconductor layers, wherein a side surface of the channel region is recessed with respect to side surfaces of the pair of thin semiconductor layers and defines a recess between the pair of thin semiconductor layers; a gate insulator separating the gate electrode from both the pair of thin semiconductor layers; and the gate electrode on the pair of thin semiconductor layers and the channel region. A portion of the gate insulator may be in the recess. In some embodiments, a portion of the gate electrode may also be in the recess.

### BRIEF DESCRIPTION OF THE DRAWINGS

FIG. 1A is a plan view of an integrated circuit device according to some embodiments.
FIGS. 1B and 1C are cross-sectional views of the integrated circuit device taken along line A-A' and B-B' in FIG. 1A, respectively, according to some embodiments.
FIG. 2 is a cross-sectional view of the integrated circuit device taken along line A-A' in FIG. 1A according to some embodiments
FIG. 3 is a flowchart of methods of forming an integrated circuit device according to some embodiments.
FIGS. 4 through 9 are cross-sectional views illustrating methods of forming an integrated circuit device according to some embodiments.

### DETAILED DESCRIPTION

Pursuant to embodiments herein, an integrated circuit device may include a stacked transistor structure including a lower transistor and an upper transistor vertically stacked on a substrate. An upper channel region of the upper transistor and a lower channel region of the lower transistor may include different materials to improve carrier mobility. At least one of the upper and lower transistors may include a pair of thin semiconductor layers contacting a channel region (e.g., the upper channel region or the lower channel region) to protect the channel region, which is between the pair of thin semiconductor layers, while forming a gate electrode (e.g., an upper gate electrode or a lower gate electrode). In some embodiments, the pair of thin semiconductor layers may protrude outwardly beyond a side surface of the channel region such that a recess may be defined between the pair of thin semiconductor layers. A capping layer may be formed in the recess before forming the gate electrode to additionally protect the channel region while forming the gate electrode.

Example embodiments will be described in greater detail with reference to the attached figures.

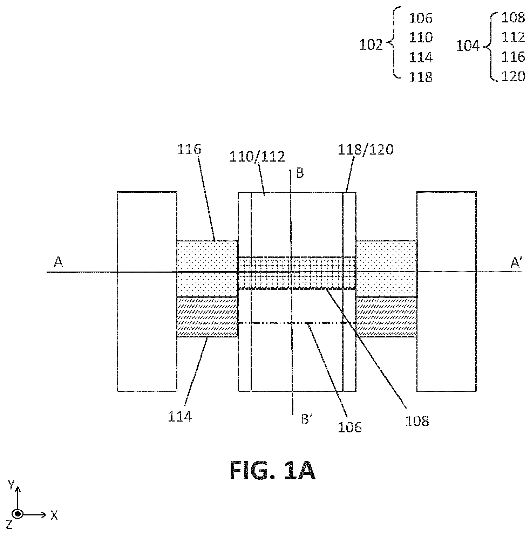

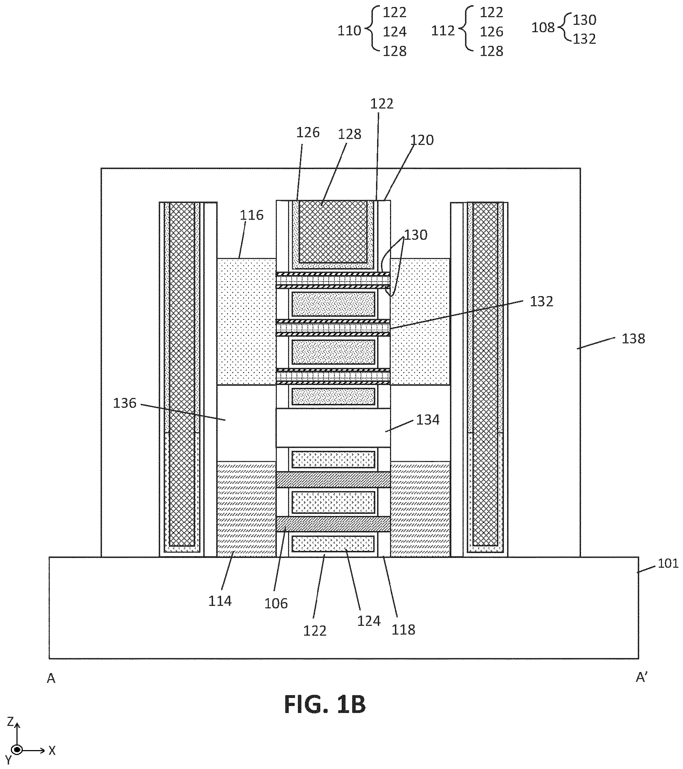

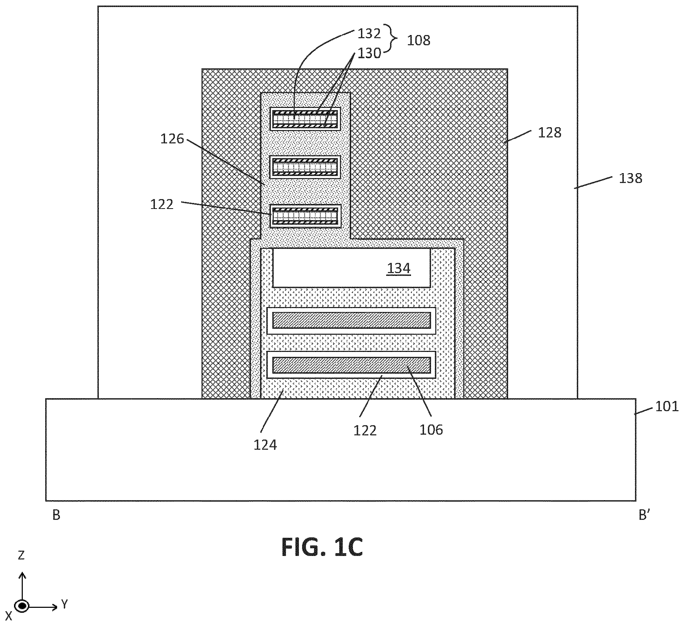

FIG. 1A is a plan view of an integrated circuit device according to some embodiments, and FIGS. 1B and 1C are cross-sectional views of a first integrated circuit device taken along line A-A' and B-B' in FIG. 1A, respectively, according to some embodiments. Referring to FIGS. 1A, 1B and 1C, the first integrated circuit device may include a first transistor 104 (also referred to as an upper transistor) and a second transistor 102 (also referred to as a lower transistor) formed on a substrate 101. The second transistor 102 may be between the substrate 101 and the first transistor 104. The first transistor 104 and the second transistor 102 may have different conductivity types or the same conductivity type. In some embodiments, the first transistor 104 may be a P-type transistor including a P-type source/drain region, and the second transistor 102 may be an N-type transistor including an N-type source/drain region. In some other embodiments, the first transistor 104 may be an N-type transistor including an N-type source/drain region, and the second transistor 102 may be a P-type transistor including a P-type source/drain region.

The first transistor 104 may include a pair of first source/drain regions 116 that are spaced apart from each other in a first direction X (also referred to as a first horizontal direction) and a channel structure 108 between the pair of first source/drain regions 116. The first direction X may be parallel to an upper surface of the substrate 101, which faces the pair of first source/drain regions 116, and/or a lower surface of the substrate 101, which is opposite the upper surface of the substrate 101. In some embodiments, the channel structure 108 may include opposing side surfaces that are spaced apart from each other in the first direction X and contact the pair of first source/drain regions 116, respectively. The channel structure 108 may include a pair of thin semiconductor layers 130 spaced apart from each other in a third direction Z (also referred to as a vertical direction) and a first channel region 132 between the pair of thin semiconductor layers 130. The first channel region 132 may contact both the pair of thin semiconductor layers 130, as illustrated in FIG. 1B. The third direction Z may be perpendicular to the upper surface of the substrate 101 and/or the lower surface of the substrate 101. In some embodiments, the third direction Z may be perpendicular to the first direction X. The pair of thin semiconductor layers 130 may include a material different from the first channel region 132.

The first transistor 104 may also include a first gate structure 112. The first gate structure 112 may include a first work function layer 126 and a first portion (e.g., an upper portion) of a metal gate layer 128. The first work function layer 126 and the first portion of the metal gate layer 128 may be referred to collectively as a first gate electrode. The first gate structure 112 may also include a first portion (e.g., an upper portion) of a gate insulator 122 separating the first gate electrode from the channel structure 108. Although FIGS. 1B and 1C illustrate that the first transistor 104 includes three channel structures 108 stacked in the third direction Z, in some embodiments, the first integrated circuit device may include one, two or more than three channel structures 108. The first transistor 104 may further include a first gate spacer 120 (also referred to as a first gate inner spacer) that is between the first source/drain region 116 and the first gate structure 112.

The second transistor 102 may include a pair of second source/drain regions 114 that are spaced apart from each other in the first direction X and a second channel region 106 between the pair of pair of second source/drain regions 114. In some embodiments, the second channel region 106 may include opposing side surfaces that are spaced apart from each other in the first direction X and contact the pair of second source/drain regions 114, respectively.

The second transistor 102 may also include a second gate structure 110. The second gate structure 110 may include a second work function layer 124 and a second portion (e.g., a lower portion) of the metal gate layer 128. The second work function layer 124 and the second portion of the metal gate layer 128 may be referred to collectively as a second gate electrode. The second gate structure 110 may also include a second portion (e.g., a lower portion) of the gate insulator 122 separating the second gate electrode from the second channel region 106. Although FIGS. 1B and 1C illustrate that the second transistor 102 includes two second channel regions 106 stacked in the third direction Z, in some embodiments, the first integrated circuit device may include one or more than two second channel regions 106. The second transistor 102 may further include a second gate spacer 118 (also referred to as a second gate inner spacer) that is between the second source/drain region 114 and the second gate structure 110.

The first source/drain region 116 and the second source/drain region 114 may overlap each other in the third direction Z, and the channel structure 108 and the second channel region 106 may overlap each other in the third direction Z, as illustrated in FIGS. 1B and 1C. As used herein, "an element A overlapping an element B in a direction X" (or similar language) means that there is at least one line that extends in the direction X and intersects both the elements A and B. FIG. 1C illustrates that the channel structure 108 has a length in a second direction Y (also referred to as a second horizontal direction), which is shorter than a length of the second channel region 106 in the second direction Y. In some embodiments, however, the channel structure 108 and the second channel region 106 may have an equal length in the second direction Y. The second direction Y may be parallel to the upper surface of the substrate 101 and/or the lower surface of the substrate 101. In some embodiments, the second direction Y may be perpendicular to the first direction X.

Although FIG. 1C illustrates that a lower portion of the first work function layer 126 overlaps the second work function layer 124 in the second direction Y, in some embodiments, the lower portion of the first work function layer 126 may not overlap the second work function layer 124 in the second direction Y, and a lower surface of the first work function layer 126 , which faces the substrate 101, may be farther than an upper surface of the second channel region 106 (e.g., an uppermost second channel region 106) from the substrate 101. Further, although FIG. 1C illustrates that both the first and second transistors 104 and 102 include portions of the metal gate layer 128, respectively, in some embodiments, the first and second transistors 104 and 102 may include different metal gate layers, respectively, and those different metal gate layers may be spaced apart from each other in the third direction Z.

Although not shown in FIG. 1B and 1C, in some embodiments, a bottom insulator extending between the substrate 101 and the pair of second source/drain regions 114 may be provided, and the pair of second source/drain regions 114 may be separated from the substrate 101 by the bottom insulator. Further, in some embodiments, the first transistor 104 including the channel structure 108 may be between the substrate 101 and the second transistor 102. In some other embodiments, both of two transistors of the first integrated circuit device may be first transistors 104, each of which includes the channel structure 108.

In some embodiments, the first integrated circuit device may further include an intergate insulator 134 between the channel structure 108 and the second channel region 106, as illustrated in FIGS. 1B and 1C. In some other embodiments, however, the intergate insulator 134 may be omitted and an entirety of an upper surface of the second work function layer 124 may contact the first work function layer 126. Additionally, the first integrated circuit device may include a first insulating layer 136 between the first source/drain region 116 and the second source/drain region 114 and may include a second insulating layer 138 on the substrate 101. The first insulating layer 136 may separate the first source/drain region 116 from the second source/drain region 114. The first transistor 104 and the second transistor 102 may be provided in the second insulating layer 138.

Although not shown in FIGS. 1B and 1C, the first integrated circuit device may also include a middle-of-line (MOL) structure and a back-end-of-line (BEOL) structure on the second insulating layer 138. The second insulating layer 138 may be between the substrate 101 and the MOL and BEOL structures. Each of the MOL and BEOL structures may include interlayer insulating layer(s) in which conductive wire(s) (e.g., metal wire(s)) and conductive via plug(s) (e.g., metal via plug(s)) are provided. Various elements of the first transistor 104 and the second transistor 102 (e.g., the first source/drain region 116 or the second source/drain region 114) may be electrically connected to one of the conductive wires of the MOL and BEOL structures.

Further, in some embodiments, a backside power distribution network structure (BSPDNS) may be provided below or within the substrate 101. In some embodiments, some elements of the BSPDNS may be provided in the substrate 101. The substrate 101 may be between the BSPDNS and the second insulating layer 138. The BSPDNS may include backside insulating layer(s) in which conductive backside wire(s) (e.g., metal power rail(s)) and conductive backside contact(s) (e.g., backside metal contact(s)) are provided. Various elements of the first transistor 104 and the second transistor 102 (e.g., the first source/drain region 116 or the second source/drain region 114) may be electrically connected to one of the conductive backside wires.

The substrate 101 may include semiconductor material(s), for example, Si, Ge, SiGe, GaP, GaAs, SiC, SiGeC and/or InP and/or may include insulating material(s), for example, silicon oxide, silicon oxynitride, silicon nitride, silicon carbonitride and/or a low-k material. In some embodiments, the substrate 101 may be a bulk substrate (e.g., a silicon wafer), a semiconductor on insulator (SOI) substrate or an insulating layer (e.g., a monolithic insulating layer). The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

Each of the first channel region 132 and the second channel region 106 may include independently, for example, semiconductor material(s) (e.g., Si, Ge, SiGe, GaP, GaAs, SiC, SiGeC and/or InP). In some embodiments, the first channel region 132 and the second channel region 106 may include different materials. For example, the first channel region 132 may be a SiGe layer, and the second channel region 106 may be a Si layer. An atomic concentration of germanium in the first channel region 132 may be about 20 % or less (e.g., about 10% or lower). In some embodiments, each of the first channel region 132 and the second channel region 106 may be a nanosheet that may have a thickness in a range of from 1 nm to 100 nm in the third direction Z or may be a nanowire that may have a circular cross-section with a diameter in a range of from 1 nm to 100 nm.

The pair of thin semiconductor layers 130 may include a material different from the first channel region 132 to have an etch selectivity with respect to the first channel region 132. For example, each of the pair of thin semiconductor layers 130 may be a Si layer (e.g., a pure Si layer devoid of dopants). In some embodiments, the channel structure 108 and the second channel region 106 may have an equal thickness in the third direction Z.

Each of the first work function layer 126 and the second work function layer 124 may include independently, for example, work function material(s) (e.g., a TiN layer, a TaN layer, a TiAl layer, a TiC layer, a TiAlC layer, a TiAlN layer and/or a WN layer). The first work function layer 126 and the second work function layer 124 may have different materials. In some embodiments, the first work function layer 126 and the second work function layer 124 may include a P-type work function material (e.g., TiN) and an N-type work function material (e.g., TiC, TiAl and/or TiAlC), respectively. The metal gate layer 128 may include, for example, tungsten (W), aluminum (Al) and/or copper (Cu).

The gate insulator 122 may include an interfacial layer and a high-k material layer sequentially stacked on the channel structure 108 and the second channel region 106. For example, the interfacial layer may be a silicon oxide layer, and the high-k material layer may include, for example, hafnium silicate, zirconium silicate, hafnium dioxide and/or zirconium dioxide.

Each of the first source/drain regions 116 and the second source/drain regions 114 may include independently, for example, semiconductor layer(s) (e.g., a silicon layer and/or a silicon germanium layer) and may additionally include dopants in the semiconductor layer(s). In some embodiments, each of the first source/drain regions 116 and the second source/drain regions 114 may also include metal layer(s) (e.g., W, Al, Cu, Mo and/or Ru).

Each of the first gate spacer 120 and the second gate spacer 118 may include independently silicon oxide, silicon oxynitride, silicon nitride and/or silicon carbonitride. Each of the intergate insulator 134 and the first and second insulating layers 136 and 138 may include independently insulating material(s) (e.g., silicon oxide, silicon oxynitride, silicon nitride, silicon carbonitride and/or a low-k material). Each of the intergate insulator 134 and the first and second insulating layers 136 and 138 may be a single layer or multiple layers stacked on the substrate 102.

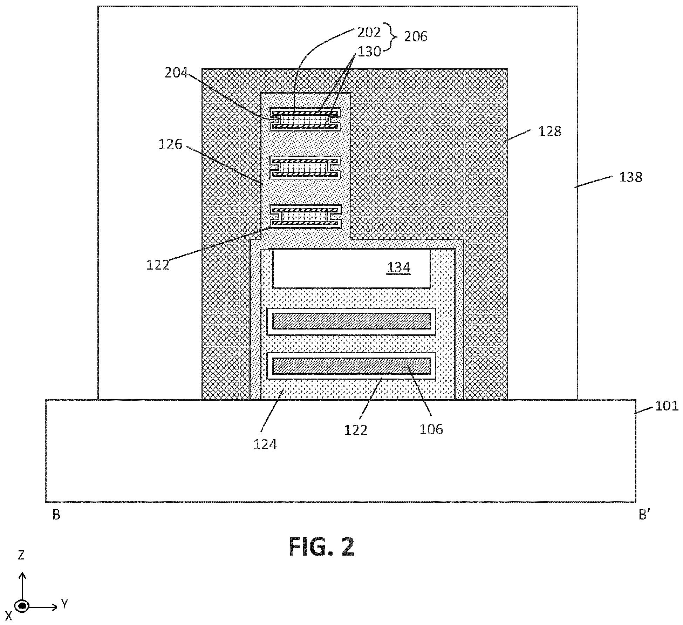

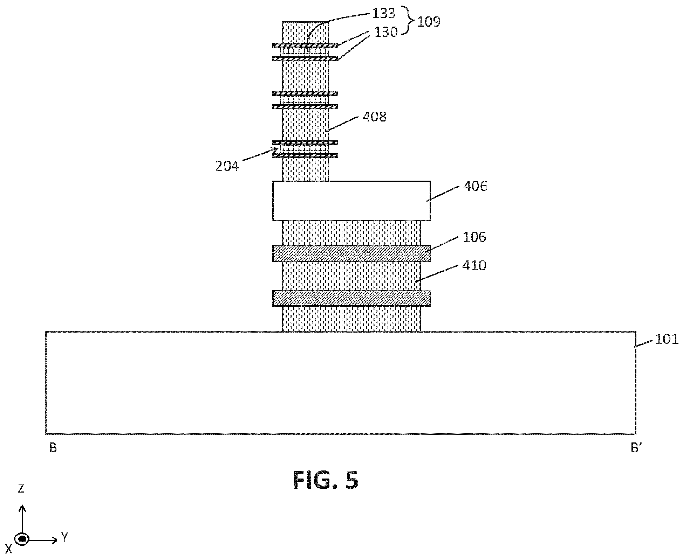

FIG. 2 is a cross-sectional view of a second integrated circuit device taken along line A-A' in FIG. 1A according to some embodiments. The second integrated circuit device illustrated in FIG. 2 may be similar to the first integrated circuit device illustrated in FIGS. 1B and 1C with the primary difference being that a first channel region 202 of a channel structure 206 is recessed with respect to side surfaces of the pair of thin semiconductor layers 130 and defines a recess 204 (also a recess 204 in FIG. 5) between the pair of thin semiconductor layers 130. A portion of the gate insulator 122 may be provided in the recess 204. That portion of the gate insulator 122 may contact the first channel region 202, as illustrated in FIG. 2. In some embodiments, a portion of the first gate electrode (e.g., a portion of the first work function layer 126) may be provided in the recess 204. The channel structure 206 may include the first channel region 202 contacting both the pair of thin semiconductor layers 130. In some embodiments, upper and lower surfaces of the first channel region 202 contact the pair of thin semiconductor layers 130, respectively.

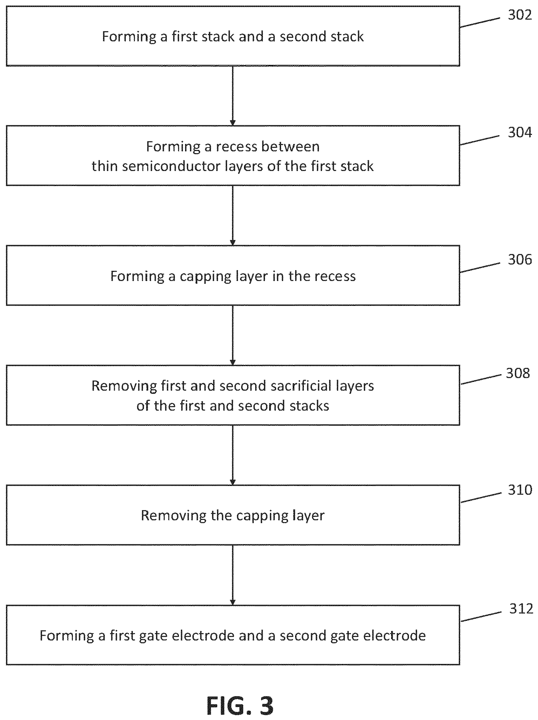

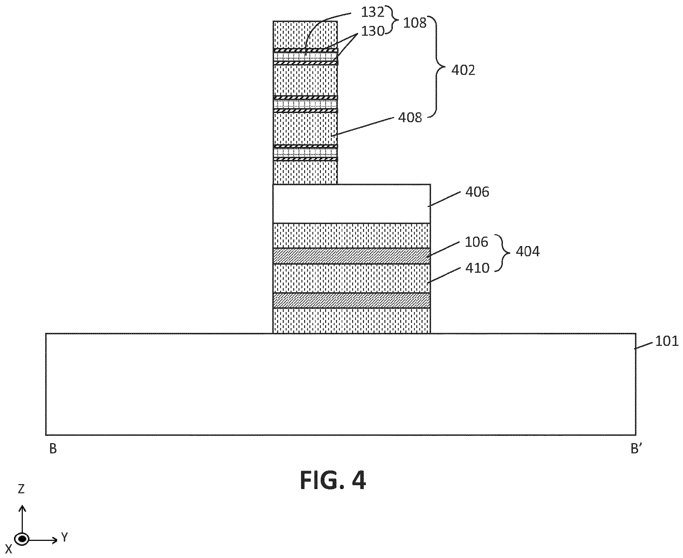

FIG. 3 is a flowchart of methods of forming an integrated circuit device according to some embodiments. FIGS. 4 through 9 are cross-sectional views illustrating methods of forming an integrated circuit device according to some embodiments.

Referring to FIGS. 3 and 4, the method may include forming a first stack 402 and a second stack 404 on a substrate 101 (Block 302). The first stack 402 may include a channel structure 108 (also referred to as a preliminary channel structure) and a first sacrificial layer 408 on the channel structure 108. In some embodiments, channel structures 108 and portions of the first sacrificial layer 408 are stacked alternately with each other in the third direction Z, as illustrated in FIG. 4. The channel structure 108 may include a pair of thin semiconductor layers 130 and a first channel region 132 (also referred to as a preliminary channel region) that is between the pair of thin semiconductor layers and contacts the pair of thin semiconductor layers. The channel structure 108 may overlap the first sacrificial layer 408 in the third direction Z. The second stack 404 may include a second channel region 106 and a second sacrificial layer 410 on the second channel region 106. In some embodiments, the second channel region 106 and portions of the second sacrificial layer 410 are stacked alternately with each other in the third direction Z, as illustrated in FIG. 4. A preliminary intergate insulator 406 may be provided between the first stack 402 and the second stack 404. Each of the first sacrificial layer 408 and the second sacrificial layer 410 may include independently, for example, semiconductor material(s) (e.g., Si, Ge, SiGe, GaP, GaAs, SiC, SiGeC and/or InP). For example, each of the first sacrificial layer 408 and the second sacrificial layer 410 may be a SiGe layer with an atomic concentration of germanium of about 20% or higher. The atomic concentration of germanium in each of the first sacrificial layer 408 and the second sacrificial layer 410 may be different from (e.g., may be higher than) the atomic concentration of germanium in the preliminary first channel region 132.

Referring to FIGS. 3 and 5, a recess 204 may be formed between the pair of thin semiconductor layers 130 (Block 304). An edge portion of the preliminary first channel region 132 may be removed to form the recess 204 that is defined by a side surface of a first channel region 133 and the pair of thin semiconductor layers 130. The recess 204 may be formed by performing an etching process (e.g., an isotropic etching process) onto the structure illustrated in FIG. 4. For example, a wet etching process and/or an isotropic dry etching process may be performed onto the structure illustrated in FIG. 4. While performing that etching process, edge portions of the first sacrificial layer 408 and the second sacrificial layer 410 may be also removed such that the pair of thin semiconductor layers 130 may protrude outwardly beyond a side surface of the first sacrificial layer 408, and the second channel region 106 may protrude outwardly beyond a side surface of the second sacrificial layer 410, as illustrated in FIG. 5. In some embodiments, the pair of thin semiconductor layers 130 may include a material different from both the first sacrificial layer 408 and the second sacrificial layer 410, and the pair of thin semiconductor layers 130 may have an etch selectivity with respect to both the first sacrificial layer 408 and the second sacrificial layer 410. Accordingly, the first sacrificial layer 408 and the second sacrificial layer 410 may be selectively etched while not etching the pair of thin semiconductor layers 130. Further, the second channel region 106 may include a material different from both the first sacrificial layer 408 and the second sacrificial layer 410, and the second channel region 106 may have an etch selectivity with respect to both the first sacrificial layer 408 and the second sacrificial layer 410.

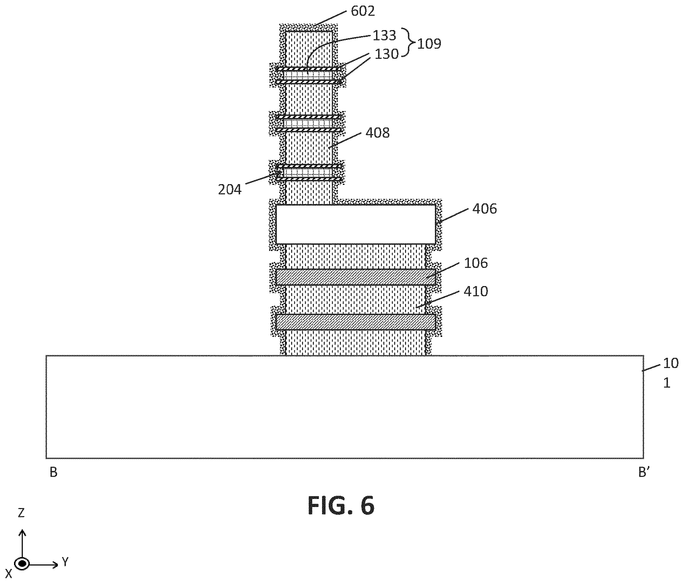

Referring to FIGS. 3, 6 and 7, a capping layer 702 may be formed in the recess 204 (Block 306). Referring to FIG. 6, a preliminary capping layer 602 may be conformally formed on the structure illustrated in FIG. 5. The preliminary capping layer 602 may have a uniform thickness and may be formed in the recess 204. In some embodiments, the preliminary capping layer 602 may fill the recess 204. The preliminary capping layer 602 may include, for example, silicon oxide, silicon oxynitride, silicon nitride and/or silicon carbonitride. In some embodiments, the preliminary capping layer 602 may be a silicon nitride layer.

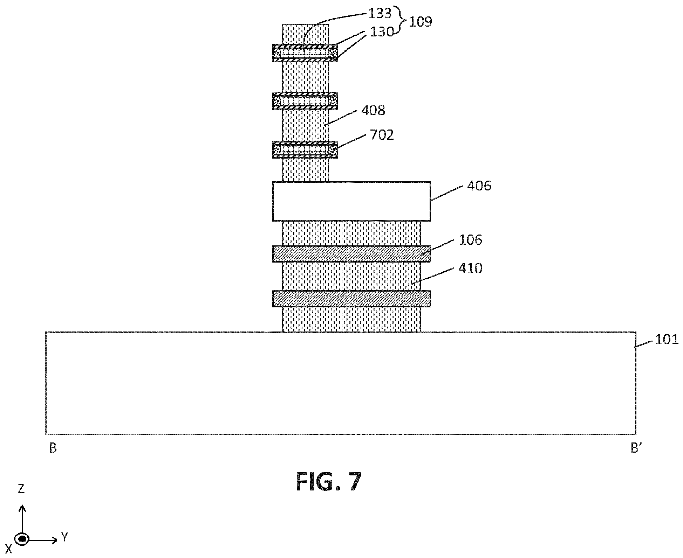

Referring to FIG. 7, a portion of the preliminary capping layer 602 formed outside the recess 204 may be removed, for example, by an anisotropic etching process. After removing the portion of the preliminary capping layer 602, the first sacrificial layer 408 and the second sacrificial layer 410 may be exposed. The portion of the preliminary capping layer 602 may not be removed during the anisotropic etching process, as the pair of thin semiconductor layers 130 protect the portion of the preliminary capping layer 602 and/or the portion of the preliminary capping layer 602 is formed in a narrow spacing between the pair of thin semiconductor layers 130.

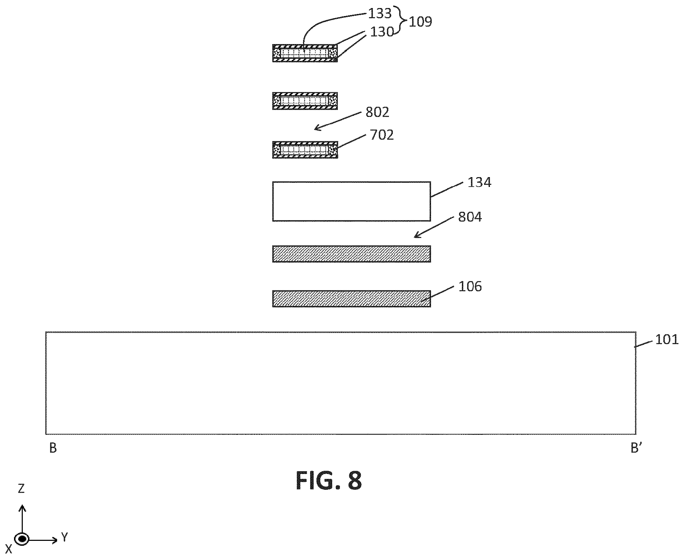

Referring to FIGS. 1B, 1C, 3, 8 and 9, the method may include replacing the first sacrificial layer 408 and the second sacrificial layer 410 with a first gate electrode and a second gate electrode, respectively, thereby forming the first gate electrode and the second gate electrode, as illustrated in FIGS. 1B and 1C. Replacing the first sacrificial layer 408 and the second sacrificial layer 410 may include removing the first sacrificial layer 408 and the second sacrificial layer 410, thereby forming a first space 802 and a second space 804, respectively (Block 308), as illustrated in FIG. 8. The first space 802 may be a space from which a portion of the first sacrificial layer 408 is removed, and the second space 804 may be a space from which a portion of the second sacrificial layer 410 is removed.

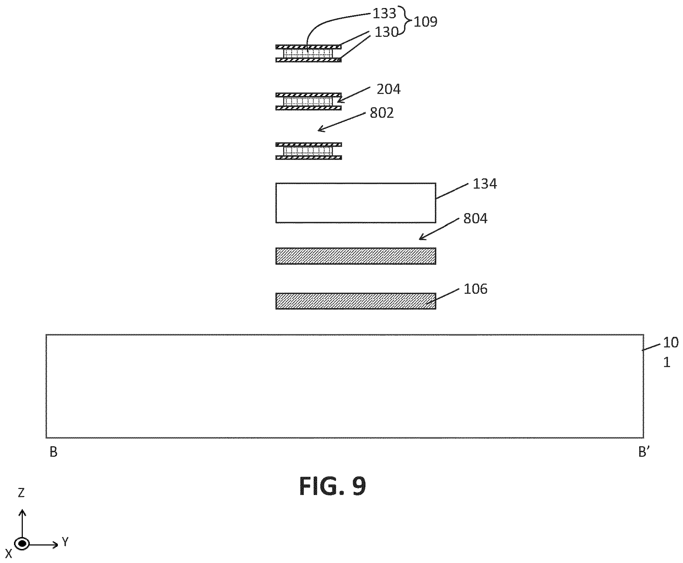

The capping layer 702 formed in the recess 204 may be removed (Block 310) such that the side surface of the first channel region 133 and edge portions of the pair of thin semiconductor layers 130 may be exposed, as illustrated in FIG. 9. Referring back to FIG. 2, the first gate electrode and the second gate electrode may be formed in the first space 802 and the second space 804, respectively.

In some embodiments, the processes described with reference to FIGS. 5 through 7 and 9 may be omitted to form the first integrated circuit device illustrated in FIGS. 1B and 1C.

In some embodiments, a transistor described herein (e.g., the first transistor 104 and the second transistor 102 in FIGS. 1A to 1C and FIG. 2) may be used as a component of an integrated circuit device or an electronic system including the integrated circuit device (e.g., a mobile phone such as a smart phone, a data storage system, and an audio system). The transistor may be used, for example, to transmit, amplify and/or switch electrical signal and may be a component of, for example, a memory device or a logic device. In some embodiments, a first signal may be applied to a first source/drain of a transistor, and a second signal (e.g., a control signal) may be applied to a gate electrode of the transistor such that electrical signal can be transmitted between first and second source/drain regions of the transistor through a channel region of the transistor. In some embodiments, the transistor may also include a storage element such that the transistor itself may store data. The transistor may include a pair of thin semiconductor layers spaced apart from each other; the channel region between the pair of thin semiconductor layers, wherein a side surface of the channel region is recessed with respect to side surfaces of the pair of thin semiconductor layers and defines a recess between the pair of thin semiconductor layers; a gate insulator separating the gate electrode from both the pair of thin semiconductor layers and the channel region; and the gate electrode on the pair of thin semiconductor layers and the channel region. A portion of the gate insulator and/or a portion of the gate electrode may be in the recess.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

As used herein, "a lower surface" refers to a surface facing a substrate (e.g., the substrate 120 in FIG. 1A), and "an upper surface" refers to a surface opposite the lower surface. Further, as used herein, "a lower portion" refers to a portion that is closer than "an upper portion" to the substrate.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive. Other embodiments and modifications of the above discussed embodiments are possible within the scope of the appended claims.

## Claims

1. An integrated circuit device comprising:
a transistor on a substrate, the transistor comprising:
a pair of thin semiconductor layers spaced apart from each other;
a channel region between the pair of thin semiconductor layers, wherein a side surface of the channel region is recessed with respect to side surfaces of the pair of thin semiconductor layers and defines a recess between the pair of thin semiconductor layers;
a gate electrode on the pair of thin semiconductor layers and the channel region; and
a gate insulator separating the gate electrode from both the pair of thin semiconductor layers and the channel region,
wherein a portion of the gate insulator is in the recess.

2. The integrated circuit device of Claim 1, wherein the transistor further comprises a pair of source/drain regions spaced apart from each other in a first horizontal direction,
wherein the channel region comprises opposing side surfaces that are spaced apart from each other in a second horizontal direction that is perpendicular to the first horizontal direction, and the side surface of the channel region is one of the opposing side surfaces.

3. The integrated circuit device of Claim 1 or 2, wherein an upper surface and a lower surface of the channel region, respectively, contact the pair of thin semiconductor layers.

4. The integrated circuit device of any one of Claims 1 to 3, wherein the pair of thin semiconductor layers comprise a material different from the channel region.

5. The integrated circuit device of any one of Claims 1 to 4, wherein a portion of the gate electrode is in the recess.

6. The integrated circuit device of any one of Claims 1 to 5, wherein the transistor is a first transistor, and the channel region is a first channel region, and
wherein the integrated circuit device further comprises a second transistor comprising a second channel region that is spaced apart from the first channel region in a vertical direction and overlaps the first channel region in the vertical direction, the first channel region comprises a material different from the second channel region, and the vertical direction is perpendicular to an upper surface of the substrate.

7. The integrated circuit device of Claim 6, wherein the second transistor is between the substrate and the first transistor.

8. A method of forming an integrated circuit device, the method comprising:
forming a first transistor and a second transistor on a substrate,
wherein the first transistor comprises a channel structure and a first gate electrode on the channel structure, and the channel structure comprises a pair of thin semiconductor layers and a first channel region that is between the pair of thin semiconductor layers and contacts the pair of thin semiconductor layers,
the second transistor comprises a second channel region and a second gate electrode on the second channel region, wherein the second channel region and the channel structure are spaced apart from each other in a vertical direction and overlap each other in the vertical direction, and
the first channel region comprises a material different from the pair of thin semiconductor layers.

9. The method of Claim 8, wherein forming the first transistor and the second transistor comprises removing an edge portion of the first channel region, thereby forming a recess that is defined by a side surface of the first channel region and the pair of thin semiconductor layers and is between the pair of thin semiconductor layers,
the first transistor further comprises a first gate insulator separating the first gate electrode from both the pair of thin semiconductor layers and the first channel region, and
a portion of the first gate insulator is formed in the recess.

10. The method of Claim 9, wherein forming the first transistor and the second transistor comprises:
forming a first stack and a second stack on the substrate, wherein the first stack comprises the channel structure and a first sacrificial layer on the channel structure, and the second stack comprises the second channel region and a second sacrificial layer on the second channel region; and
replacing the first sacrificial layer and the second sacrificial layer with the first gate electrode and the second gate electrode, respectively.

11. The method of Claim 10, further comprising forming a capping layer in the recess before replacing the first sacrificial layer and the second sacrificial layer with the first gate electrode and the second gate electrode,
wherein replacing the first sacrificial layer and the second sacrificial layer with the first gate electrode and the second gate electrode comprises:
removing the first sacrificial layer and the second sacrificial layer, thereby exposing the capping layer;
removing the capping layer, thereby forming the recess that exposes the side surface of the first channel region; and then
forming the first gate electrode in the recess and in a space from which the first sacrificial layer is removed and forming the second gate electrode in a space from which the second sacrificial layer is removed.

12. The method of any one of Claims 8 to 11, wherein forming the first transistor and the second transistor comprises forming a P-type source/drain region contacting the first channel region and an N-type source/drain region contacting the second channel region.

13. The method of any one of Claims 8 to 12, wherein the second channel region comprises a material different from the first channel region.
